Europäisches Patentamt

European Patent Office

Office européen des brevets

(11) Veröffentlichungsnummer: **0 151 737**
**B1**

(12) **EUROPÄISCHE PATENTSCHRIFT**

(45) Veröffentlichungstag der Patentschrift: **27.06.90**

(21) Anmeldenummer: **84115049.3**

(22) Anmeldetag: **10.12.84**

(51) Int. Cl.[5]: **C 23 C 14/54,** G 01 R 27/00,
G 05 D 5/03, H 01 C 17/08

(54) **Verfahren zur Kontrolle und Regelung des Einbaus von Dotiergasen in elektrisch leitende metallische Schichten w/hrend ihrer Herstellung.**

(30) Priorität: **16.02.84 DE 3405625**

(43) Veröffentlichungstag der Anmeldung:
**21.08.85 Patentblatt 85/34**

(45) Bekanntmachung des Hinweises auf die
Patenterteilung:
**27.06.90 Patentblatt 90/26**

(84) Benannte Vertragsstaaten:
**AT CH DE FR GB IT LI**

(56) Entgegenhaltungen:
**EP-A-0 082 654**
**FR-A-2 099 098**
**FR-A-2 334 962**
**FR-A-2 476 633**
**GB-A-1 446 849**
**US-A-3 709 192**

**SIEMENS FORSCH.- UND ENTWICKL.-BER.,
Band 11, Nr. 6, 1982, Seiten 322-326, Springer-
Verlag, Berlin, DE; N.M. MAYER: "Resistance
measurements by radio telemetric system
during film deposition by sputtering"**

(73) Patentinhaber: **Siemens Aktiengesellschaft
Wittelsbacherplatz 2
D-8000 München 2 (DE)**

(72) Erfinder: **Hieber, Konrad, Dr. rer. nat.
Laubensteinstrasse 7
D-8214 Bernau (DE)**
Erfinder: **Mayer, Norbert, Dr. rer. nat.
Werdenfelsstrasse 77
D-8000 München 70 (DE)**

# EP 0 151 737 B1

**Beschreibung**

Die Patentanmeldung betrifft ein Verfahren zur Kontrolle und Regelung des Einbaus von Dotiergasen in elektrisch leitende metallische Schichten, wie sie insbesondere in der Halbleiter- und Dünnschichttechnologie verwendet werden, während der Schichtherstellung durch Aufdampfen oder Aufstäuben.

An die Toleranz und Konstanz der elektrischen Eigenschaften metallischer Schichten werden in der Halbleiter- und Dünnschichttechnik extrem hohe Anforderungen gestellt. Der Temperaturkoeffizient des elektrischen Widerstandes, zum Beispiel eines Dünnschichtwiderstandes aus Chrom-Nickel, Aluminium-Tantal oder Tantal-Oxinitrid ($TaO_xN_y$) darf nur wenige $10^{-6}$ $K^{-1}$ betragen. Ferner darf sich der Widerstandswert der Schichten innerhalb von vielen Jahren nur um wenige Prozent ändern.

Bei Chrom-Nickel-Sauerstoff-Dünnschicht-Widerständen wird der Temperaturkoeffizient des elektrischen Widerstandes, der zum Beispiel im Bereich von $-25$ bis $+25\times10^{-6}$ $K^{-1}$ liegen muß, sehr empfindlich vom Sauerstoffeinbau beeinflußt. Um diese Werte reproduzierbar einhalten zu können, darf die Sauerstoffkonzentration nur um $\pm5$ Mol % schwanken. Außerdem beeinflußt der Sauerstoffgehalt in den Schichten auch erheblich die Stabilität der Schichten bei thermischer Belastung.

Aus dem Stand der Technik ist zur Überwachung und Regelung des Einbaus von Dotiergasen in elektrisch leitende Schichten eine indirekte Methode bekannt, welche auf folgendem berührt.

Mit Hilfe eines Massenspektrometers wird der Partialdruck des Dotiergases in der Beschichtungskammer konstant gehalten. Speziell bei der Schichtherstellung durch Aufstäuben hat diese Methode den Nachteil, daß das Massenspektrometer nur über eine Druckstufe mit dem Beschichtungsraum verbunden sein kann (Druck im Beschichtungsraum ca. $10^{-2}$ mbar, Druck im Massenspektrometer ca. $10^{-5}$ mbar). Ein weiterer Nachteil ist, daß bei dieser Methode nicht der Anteil des in die Schicht tatsächlich eingebauten Gases erfaßt werden kann, das heißt, daß die Auswirkungen des Dotiergaseinbaus auf die Schichteigenschaften eigentlich nicht der Kontrolle oder Regelung unterliegen.

Um Schichten mit speziellen Eigenschaften zu erhalten, müssen bei dieser indirekten Methode viele Versuche durchgeführt werden, um den optimalen Dotiergasdruck zu finden. Die elektrischen Schichteigenschaften können immer nur nach der Schichtherstellung bestimmt werden. Bei der fertigungsmäßigen Herstellung der Schichten muß dann darauf geachtet werden, daß dieser Dotiergasdruck möglichst exakt eingehalten wird. Nach der Fertigstellung der Schicht wird dann geprüft, ob die Schicht die geforderten elektrischen Eigenschaften besitzt. Erst dann kann entschieden werden, ob die Schicht die gestellten Bedingungen erfüllt.

Bei dem Verfahren der indirekten Kontrolle und/oder Regelung des Dotiergaspartialdrucks in der Beschichtungskammer mit Hilfe eines Massenspektrometers treten je nach Toleranzgrenzen Ausschußraten von bis zu 50% auf. Dadurch entstehen unter Umständen hohe Kosten, da die zum Beispiel integrierte Halbleiterschaltungen enthaltenden Substrate bevor sie mit Metallschichten bedampft werden, oft schon viele Prozeßschritte durchlaufen haben.

In der DE—OS 30 04 149 ist ein Verfahren beschrieben worden, mit dem es möglich ist, metallische Schichten reproduzierbar herzustellen. Dabei wird zur dynamischen Steuerung des Beschichtungsprozesses fortlaufend eine Reihe von Istwerten ($\rho\infty$, $I\infty$, p, h) ermittelt und errechnet und mit Sollwerten verglichen. Bei Abweichungen der Ist- von den Sollwerten werden die Beschichtungsparameter wie Substrattemperatur, beschichtungsrate, Dotiergasdruck und Schichtzusammensetzung geeignet verändert. Dieses in der DE—OS 30 04 149 beschriebene Verfahren hat einen wesentlichen Nachteil:

Zur Errechnung der 4 Ist-Werte muß eine relativ komplizierte Formel auf iterativem Wege gelöst werden, was großen Rechenaufwand innerhalb kürzester Zeit zur Folge hat, der nur von teueren Rechenanlagen bewältigt werden kann. Außerdem sind vier Regelgrößen und vier Stellglieder beschrieben.

Aufgabe der Erfindung ist es daher, ein einfaches Verfahren anzugeben, das es ermöglicht, noch während der Herstellung, die durch Aufdampfen oder Aufstäuben erfolgt, den Einbau von Dotiergasen in die Schicht zu kontrollieren und/oder zu regulieren. Desweiteren soll es das Verfahren ermöglichen, daß nicht nur ein konstanter, sondern auch ein mit der Schichtdicke variiernder Dotiergaseinbau erfolgen kann. Das Verfahren soll so einfach sein, daß keine größeren iterativen Berechnungen zur Ermittlung der Regelgrößen nötig sind und daß nur eine einzige Regelgröße verwendet wird im Gegensatz zum bekannten Verfahren, wie es in der DE—OS 30 04 149 beschrieben ist.

Weiterhin ist es auch Aufgabe der Erfindung, diese auf die Herstellung von zum Beispiel Widerstandsschichten bzw. auf Schichten mit definierten Dotierungsprofilen anzuwenden.

Zur Lösung der erfindungsgemäßen Aufgabe wird ein Verfahren der eingangs genannten Art vorgeschlagen, das dadurch gekennzeichnet ist, daß

a) fortlaufend der momentane elektrische Schichtwiderstand $R_i$ und die momentane Schichtdicke $d_i$ gemessen bzw. bestimmt werden,

b) daraus der Istwert der Regelgröße $\rho\infty_i$ ermittelt wird,

c) der Istwert mit dem Sollwert von $\rho\infty_i$ für die Schichtdicke $d_i$ verglichen wird und

d) bei Regelabweichungen (Soll-Istwert-Differenzen) die Dosierung des Einlaßventils für das Dotiergas in den beschichtungsraum als Stellgröße entsprechend verändert wird und

e) bei Erreichen eines bestimmten Endwertes der Beschichtungsvorgang beendet wird.

2

Die Istwerte der Regelgröße $\rho\infty_i$ ergeben sich im Normalfall aus mindestens zwei Produkten $(\rho \cdot d)_i$ und $(\rho \cdot d)_{i-j}$ $(1 \leq j < i)$, mit $(\rho \cdot d)_i = \rho_i \cdot d_i$, oder im Spezialfall des lagenweisen Aufbringens der Schicht aus dem Lagenwiderstand $R_{Li}$ der gerade aufgebrachten Schicht.

Die Sollwerte von $\rho\infty_i$ können entweder über den gesamten Schichtdickenbereich konstant sein, wie es insbesondere für die Herstellung von metallisch leitenden Schichten zum Beispiel Widerstandsschichten der Fall ist, oder sie ändern sich mit der Schichtdicke, wie es insbesondere für die Erzeugung von Konzentrationsgradienten oder Diffusionsbarrieren in der Schicht nötig ist.

Im einfachsten Fall, wenn nur eine Kontrolle des Schichtherstellungsprozesses gewünscht wird, werden nur die Istwerte der Regelgröße $(\rho \cdot d)_i$ kontinuierlich aufgezeichnet.

Die erfindungsgemäße Regelung wird bevorzugt bei Schichtherstellungen durch Aufdampfen oder durch Aufstäuben (Sputtern) angewendet. Hierbei kann die Schichtdicke aus der Schichtherstellungszeit berechnet werden, da die Aufdampfrate oder die Aufstäubrate (Sputterrate) (=aufgetragene Schichtdicke pro Zeiteinheit) konstant ist.

Als Schichtherstellungsprozess werden bevorzugt das Aufdampfen im Vakuum (Druck$<10^{-5}$ mbar) und das Aufstäuben verwendet, wobei die Beschichtungsrate üblicherweise konstant gehalten wird. Beim Aufbringen der Schichten kann das Material kontinuierlich oder mit zeitlichen Unterbrechungen, das heißt diskontinuierlich, aufgebracht werden.

Beim diskontinuierlichen Aufbringen der Schichten werden üblicherweise die zu beschichtenden Substrate unter der Materialquelle, die mit einer konstanten Beschichtungsrate arbeitet, zyklisch hindurchbewegt, so daß die Schichten lagenweise aufgebracht werden. Weitere Einzelheiten sind aus einem Aufsatz von K. Hieber, Siemens Forsch.-u. Entwickl.-Ber. Bd. 11 (1982), Seiten 145 bis 148, zu entnehmen.

Bei jeder aufgebrachten Schichtfolge erniedrigt sich der Schichtwiderstand stufenartig (vergleiche dazu Aufsatz von N. M. Mayer, Siemens Forsch.-u. Entwickl.-Ber. Bd. 11 (1982), Seiten 322 bis 326).

Speziell beim gleichzeitigen Zerstäuben von mehreren Targets ("Co-Sputtern") wird diese Methode des lagenweisen Aufbringens von Teilschichten angewandt.

Gegenstand der vorliegenden Erfindung ist es also, den Prozeß der Herstellung von elektrisch leitenden Schichten dynamisch zu regeln, das heißt, noch während der Herstellung der Schicht—wenn nötig—den Fremdgaseinbau in die Schicht über die Dosierung eines Gaseinlaßventils zu verändern.

Bezüglich der Regelgröße wäre folgendes auszuführen:

a) Allgemeiner Fall

Die Erfindung geht von der Erkenntnis aus, daß die Größe $\rho\infty_i$ als Regelgröße geeignet ist, den Einbau von Fremdgasen in die Schicht, die gerade hergestellt wird, aufzuzeigen. Mißt man während der Schichtherstellung den spezifischen elektrischen Widerstand $\rho$ in Abhängigkeit von der Schichtdicke d und trägt das Produkt aus $\rho \cdot d$ gegen d graphisch auf, so erhält man im Idealfall für $d > l\infty$ ($l\infty$ mittlere freie Weglänge der Elektronen) einen linearen Zusammenhang gemäß der Formel von Sondheimer (H. Hoffmann, J. Vancea, Thin Solid Films, 85 (1981), Seiten 147 bis 167).

$$\rho \cdot d = \rho\infty \cdot d + 3/8\, \rho\infty\, l\infty\, (1-P) \tag{1}$$

mit P als sogenanntem Spiegelungsparameter und $\rho\infty$ als dem spezifischen elektrischen Widerstand der Schicht bei "unendlicher" Schichtdicke, das heißt keine Beeinflussung der elektrischen Leitfähigkeit durch Dünnschichteffekte.

Aus (1) ergibt sich als 1. Ableitung nach d (Differentiation nach d)

$$\frac{\Delta(\rho \cdot d)}{\Delta d} = \rho\infty \tag{2}$$

das heißt, die Steigung der Geraden in der $\rho \cdot d$ gegen d Darstellung entspricht $\rho\infty$.

Das Besondere an der Größe $\rho\infty$ ist, daß diese Größe zu jedem Zeitpunkt während der Schichtherstellung angibt, welchen spezifischen elektrischen Widerstand das Material momentan hat, das auf die entstehende Schicht aufgebracht wird, während der direkt gemessene und ermittelte spezifische elektrische Widerstand (aus $R = \rho \cdot l/q \cdot d$ mit R als gemessenem Widerstand, l als Länge und q als Breite der Meßstrecke) immer nur integral den spezifischen elektrischen Widerstand der Schicht angibt.

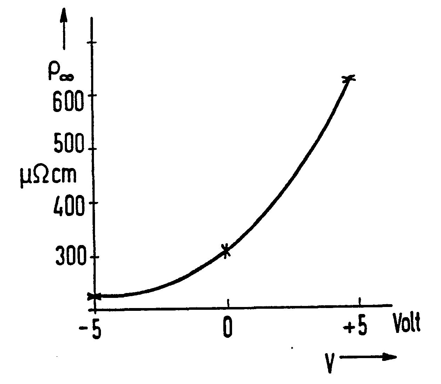

Der Einbau von Fremdgasen in die Schicht ändert den spezifischen elektrischen Widerstand des Materials, das aufgebracht wird, was eine Änderung von $\rho\infty$ zur Folge hat. Ein Beispiel ist in der Veröffentlichung Siemens Forsch-u. Entwickl.-Ber. Bd. 11 (1982) Nr. 5, Figur 8, zu sehen, wo die Änderung der Steigung in der $\rho \cdot d$ gegen d-Darstellung und die Änderung von $\rho\infty$ bei einer Änderung des $O_2$-Gehaltes in der Sputteratmosphäre während der Herstellung von Ta-Schichten gezeigt wird.

Während der Schichtherstellung muß demnach der elektrische Schichtwiderstand fortlaufend gemessen werden; bevorzugt ist die Messung an einem Referenzsubstrat, wo die Schicht mit einer definierten Geometrie hergestellt wird. Der spezifische elektrische Widerstand ergibt sich dann nach der bekannten Formel $\rho = R \cdot d \cdot q/l$. Die Widerstandsmessung erfolgt bevorzugt durch die 2- oder 4-Punkt

3

Widerstandsmeßmethode mit Gleich- oder Wechselstrom. Zur Messung des elektrischen Widerstandes in Anlagen mit Vakuumschleuse und bewegten Substraten wird bevorzugt eine Widerstandsmeß- und Übertragungsapparatur verwendet, wie sie in Siemens Forsch.- und Entwickl.-Ber. 11 (1982), Seiten 322 bis 326, beschrieben ist.

Die Schichtdicke kann mit den üblichen bekannten Verfahren gemessen werden, zum Beispiel Schwingquarz, optische Interferenzmethoden. Bevorzugt ist es, bei konstanten Beschichtungsraten (insbesondere Aufdampfrate oder Aufstäubrate) die momentane Schichtdicke aus dem Produkt Beschichtungszeit t und Beschichtungsrate zu ermitteln (errechnen); bei der diskontinuierlichen (lagenweisen) Schichtherstellung läßt sich die momentane Schichtdicke auch aus der Anzahl der aufgebrachte Teillagen und der Dicke einer Teillage errechnen, die ebenso wie die Beschichtungsrate in Vorversuchen bestimmt wird.

Somit wird während der Schichtherstellung fortlaufend ein Wertepaar $R_i$, $d_i$ gemessen oder speziell $d_i$ ermittelt und daraus $\rho_i$ und $(\rho \cdot d)_i$ errechnet:

|  | erster Wert $\downarrow$ | Endwert |
|---|---|---|
| Widerstand (gemessen) | $R_1 .. R_j .. R_i .. R_{n-1}$ | $R_n$  $0 < j < i$ |
| Schichtdicke gemessen oder errechnet) | $d_1 .. d_j .. d_i .. d_{n-1}$ | $d_n$ |
| spez. elektr. Widerstand | $\rho_1 .. \rho_j .. \rho_i .. \rho_{n-1}$ | $\rho_n$ |
| Produkt | $(\rho \cdot d)_1 .. (\rho \cdot d)_j .. (\rho \cdot d)_i .. (\rho \cdot d)_{n-1}$ | $(\rho \cdot d)_n$ |
| Istwert der Regelgröße | $—$    $\overline{\rho\infty}_j .. \rho\infty_i .. \rho\infty_{(n-1)} .$ | $\rho\infty_n$ |

Der Istwert der Regelgröße $\rho\infty_i$ ergibt sich aus den Wertepaaren von $(\rho \cdot d)_i$ und $d_i$ nach den üblichen Formeln zur Berechung von Steigungen von Geraden unter Zugrundelegung von einem oder mehreren Wertepaaren für $j < i$, die zuletzt bestimmt werden, und dem aktuellen Wertepaar i.

Speziell für 2 Wertepaare gilt:

$$\rho\infty_i = \frac{(\rho \cdot d)_i - (\rho \cdot d)_j}{d_i - d_j} \qquad \begin{array}{c} (i>1) \\ \text{speziell: } j = i-1 \end{array} \qquad (3)$$

Bei Verwendung von 3 oder mehr Wertepaaren zur Berechnung von $\rho\infty_i$ können entsprechende Formeln verwendet werden, wie sie in den mathematischen Formelsammlungen für Ausgleichsgeraden durch mehrere Punkte angegeben werden.

Bei der kontinuierlichen Schichtherstellung ergibt sich der zeitliche Abstand zwischen zwei Bestimmungen des Ist-wertes der Regelgröße aus der Beschichtungsrate. Bevorzugt ist eine neue Bestimmung des Istwertes der Regelgröße nach dem Aufbringen von jeweils einer Schichtdicke $\Delta d$ von 0,5 bis 50 nm, besonders bevorzugt von 1 bis 20 nm, das heißt bei einer Beschichtungsrate von zum Beispiel 10 nm/sec ist es besonders günstig, alle 0,2 bis 2 sec einen neuen Istwert der Regelgröße zu bestimmen. Erfolgt die Schichtherstellung dagegen diskontinuierlich, das heißt lagenweise, ist es günstig, den Istwert der Regelgröße jeweils nach einem Durchgang des Substrats, an dem gemessen wird, unter allen Beschichtungsquellen (zum Beispiel 2 oder mehrere beim Co-Sputtern) zu bestimmen. Bei Verwendung einer Drehpalette wie sie zum Beispiel in einer Perkin-Elmer-Sputteranlage (PE 4400) eingesetzt wird, erfolgt dann die Istwertbestimmung nach jeweils einer Palettenumdrehung.

b) Spezialfall

Im Falle der lagenweisen (diskontinuierlichen) Schichtherstellung ist es speziell möglich, als Istwert der Regelgröße den Langewiderstand $R_{Li}$ der i-ten Teillage zu verwenden. Durch das diskontinuierliche Aufbringen der Schicht erniedrigt sich der Schichtwiderstand mit jeder neuafugebrachten Lage stufenartig. Aus den Widerstandsänderungen von Stufe zu Stufe läßt sich der Widerstand der einzelnen, gerade aufgebrachten Lage berechnen, der abgesehen von der ersten Lage—bei konstanten Herstellbedingungen (Beschichtungsrate der Quelle, konstanter Einbau des Dotiergases) einen festen Wert besitzt.

Elektrisch kann diese Schichtfolge durch eine Reihe von Parallelschaltungen von Widerständen angesehen werden.

Der Gesamtwiderstand $R_{Gi}$ nach der i-ten Lage ergibt sich aus:

$$\frac{1}{R_{Gi}} = \frac{1}{R_{G(i-1)}} + \frac{1}{R_{Li}} \tag{4}$$

mit $R_{Li}$ als dem Lagenwiderstand der i-ten Lage.

| | Erste Lage | | | n-te Lage |
|---|---|---|---|---|
| Gesamt- widerstand gemessen | $R_{G1}$ | $R_{G2} \ldots R_{Gj} \ldots R_{G(i-1)} R_{Gi} \ldots$ | | $R_{Gn}$=Endwiderstand |
| Lagen- widerstand | — | $R_{L2} \ldots R_{Lj} \ldots R_{Li} \ldots$ | | $R_{Ln}$ |

Der momentane Lagenwiderstand $R_{Li}$ errechnet sich dann aus:

$$R_{Li} = \frac{R_{Gi} \cdot R_{G(i-1)}}{R_{G(i-1)} - R_{Gi}} \quad i>1) \tag{5}$$

das heißt, aus dem Schichtwiderstand vor und nach dem Aufbringen der Teillage i.

Bei konstanten Herstellbedingungen ist $R_{Li}=R_{Lj}$ mit $i \neq j$ und $1<i\leq n$. Ändert sich der in die Schicht eingebaute Gasanteil, so ändert sich auch $R_{Li}$.

Da das erfindungsgemäße Verfahren diesen Spezialfall mit einschließt, soll bei Verwendung des Lagenwiderstandes als Regelgröße

$$\rho\infty_i = R_{Li} \tag{6}$$

gesetzt werden, das heißt, im allgemeinen Fall ergibt sich $\rho\infty_i$ aus der Anwendung der Formeln (1) und (2), die zu der speziellen Formel (3) führt, und im oben aufgezeigten Spezialfall ergibt sich $\rho\infty_i$ aus der Formel (5) und (6).

Die Sollwerte der Regelgröße liegen vor der Schichtherstellung fest. Im Fall von Schichten mit konstantem Gaseinbau über den gesamten Schichtquerschnitt, wie es insbesondere bei Widerstandsschichten der Fall ist, ist der Sollwert eine konstante Größe, die dem gewünschten spezifischen elektrischen Widerstand der Schicht entspricht. Der Sollwert von $\rho\infty = \rho\infty_i = \rho\infty_j$ ist somit unabhängig von der Schichtdicke.

Im anderen Fall hängt der Sollwert der Regelgröße von der Schichtdicke ab, das heißt, jedem Schichtdickenwert $d_i$ entspricht ein eigener Sollwert von $\rho\infty_i$. Diese Sollwerte können entweder theoretisch oder experimentell festgelegt werden, das heißt, im letzteren Fall wird zunächst eine Schicht hergestellt, wobei zum Beispiel von Hand das Dosierventil für den Gaseinlaß in die Beschichtungskammer verändert wird und die Istwerte von $\rho\infty_i$ bestimmt und aufgezeichnet (gespeichert) werden, und wenn sich die so hergestellte Schicht in nachfolgenden Testuntersuchungen als geeignet herausgestellt hat, können diese Istwerte von $\rho\infty_i$ bei der späteren fertigungsmäßigen Schichtherstellung als Sollwerte verwendet werden.

Die gemessenen Istwerte der Regelgröße $\rho\infty_i$ werden während der Schichtherstellung fortlaufend mit den Sollwerten verglichen, das heißt mit dem für die entsprechende aktuelle Schichtdicke aktuellen Sollwert.

Bei Soll-Istwert-Differenzen, das heißt Regelabweichungen, wird über ein entsprechendes Stellglied der Dotiergasanteil in der Beschichtungskammer geeignet geändert. Dies geschieht im einfachsten Fall über ein Gasdosierventil, das den Fremdgaseinlaß in die Beschichtungskammer steuert. Durch dieses Verstellen der Stellgröße (Fremdgasanteil in der beschichtungskammer) bei Soll-Istwert-Differenzen kann die Regelgröße an die Führungsgröpe (=Sollwert der Regelgröße) angeglichen werden.

Die Richtung der Verstellung der Stellgröße ist eindeutig: da ein Fremdatomeinbau in eine Schicht stets den spezifischen elektrischen Widerstand des Materials erhöht, muß bei einem zu hohen Istwert von $\rho\infty_i$ der Anteil des Fremdgases in der Beschichtungskammer verringert werden, das heißt, das Gasdosierventil muß gedrosselt werden. Dagegen muß bei einem zu niedrigen $\rho\infty_i$-Wert der Anteil des Fremdgases durch eine Erweiterung der Öffnung des Gasdosierventils erhöht werden muß.

Um wieviel der Fremdgasanteil bei Regelabweichungen verändert werden muß, kann durch geeignete Vorversuche ermittelt werden, vergleiche zum Beispiel Siemens Forsch.- und Entwickl.-Ber. Bd. 11 (1982), Nr. 6, Seiten 322 bis 326, Figur 8+Tabelle 2: $\rho\infty$ als Funktion der Gaseinlaßdotierung.

Im einfachsten Fall erfolgt die stetige Regelung bevorzugt in der bekannten Art der P-Regler (Proportional-Regler). Eine stetige Regelung nach der bekannten Art der I-, PI-, PD- oder PID-Regeler ist ebenfalls möglich (I=Integral; D=Differential).

Bezüglich dieser Antwortfunktionen (zeitabhängiger Zusammenhang zwischen der Änderung der Ein- und Ausgangsgrößen) wird auf den Stand der Technik verwiesen, wie er insbesondere aus Dubbel, Taschenbuch für den Maschinenbau, 14. Auflage 1981, Seiten 1267 bis 1282 und 1446 bis 1448 und der dort genannten Literatur hervorgeht.

Die Ermittlung (Berechnung) der Istwerte von $\rho\infty_i$, der Vergleich mit den Sollwerten und die Steuerung des Gasdosiersystems wird bevorzugt durch einen Prozeßrechner (Kleincomputer) durchgeführt. Das Gasdosiersystem kann von einem Rechner leicht über einen Digital/Analog-Wandler gesteuert werden. Im Falle einer konstanten Führungsgröße ($\rho\infty_i$=konst.) sind auch hardware-mäßige Schaltungsausführungen möglich, bestehend aus einem analogen Multiplikator zur Berechnung der Istwerte, einem Komperator zur Bestimmung der Regelabweichung und einem Spannungsgeber zur Steuerung des Gaseinlaßventils.

Ein Prozeßrechner hat gegenüber einer festen Schaltungsanordnung den entscheidenden Vorteil, daß eine wesentlich höhere Flexibilität für unterschiedliche Schichtherstellungsprozesse erreicht wird.

Der Beschichtungsprozeß wird beendet, wenn ein vorher festgelegter Endwert erreicht wird; es können hierzu eine Reihe von Werten verwendet werden:

zum Beispiel Schichtwiderstand, Flächenwiderstand, spezifischer elektrischer Widerstand, Schichtdicke, Beschichtungszeit.

Das Beenden des Beschichtungsprozesses kann insbesondere durch Abschalten der Materialquelle(n) oder durch Schließen von Blende(n) zwischen Materialquelle(n) und hergestellter Schicht erfolgen. Wenn während der Schichtherstellung eine Anpassung der Ist-Werte an die Sollwerte nicht mehr möglich ist, kann unter Umständen der Beschichtungsprozeß abgebrochen werden.

Im Falle der Kontrolle des Schichtherstellungsprozesses findet kein Vergleich von Ist- und Sollwerten statt. Die Istwerte von $\rho\infty_i$ werden dann nur aufgezeichnet zum Beispiel auf Papier, Bildschirm oder gespeichert zum Beispiel auf einer Floppy-Disk oder Hard-Disk. Ohne weitergehende Prüfung der Schichten kann dann entschieden werden, ob die gerade hergestellten Schichten den "Soll-Schichten" gleichen und ob weitere Fertigungsschritte sinnvoll sind oder ob die Schichten als Ausschuß angesehen werden müssen.

Das Verfahren mit konstanter Führungsgröße findet bevorzugt Anwendung bei der Herstellung von elektrischen Widerstandsschichten zum Beispiel Ta, Cr-Ni, Cr-Si mit Hilfe von mehr oder weniger reaktiven Fremdgasen: zum Beispiel $O_2$, $N_2$, Ar und/oder $H_2$.

Das Verfahren mit variabler Führungsgröße kann bevorzugt angewendet werden zum Beispiel zur Erzeugung einer Passivierungsschicht, wobei nahe der Endschichtdicke zum Beispiel der $O_2$-Gehalt in der Schicht erhöht wird.

Eine andere Anwendung ist die Erzeugung eines besseren Kontaktes oder Haftung zwischen Substrat und Schicht. In diesem Fall würde sich der Sauerstoffgehalt in der Schicht störend auswirken. Deshalb wird die Schicht zunächst ohne Fremdgaseinbau aufgebracht bis eine vorbestimmte Schichtdicke erreicht ist, erst dann erfolgt zum Beispiel ein konstanter Fremdgaseinbau (zum Beispiel bei Widerstandsschichten).

Eine andere Anwendung ergibt sich im Falle der Dotierung von Silizium mit $H_2$, wobei Schichten mit definierten elektrischen Eigenschaften hergestellt werden sollen.

Das Verfahren kann ferner Anwendung finden, um Diffusionsbarrieren in einer Schicht zu erzeugen, wenn zum Beispiel nur in einem bestimmten Schichtdickenbereich ein Fremdgaseinbau stattfindet. So kann zum Beispiel in einer Ta-Si-Schicht, die auf Si abgeschieden wurde, durch kurzzeitigen Einlaß von Stickstoff eine Ta-Si-N-Zwischenschicht erzeugt werden, die bei späteren Temperschritten die Diffusion von Si in die Ta-Si-Schicht unterbindet.

Die beschriebene Kontrolle und/oder Regelung des Schichtherstellungsprozesses hat den großen wirtschaftlichen Vorteil, daß eine gezielte in höchstem Maße reproduzierbare Fertigung von dünnen Schichten möglich ist, wodurch erhebliche Kosten eingespart werden können.

Ausführungsbeispiele

Die elektrischen Widerstandsmessungen werden während der Schichtherstellung mit einer in-situ-Widerstandsmeßvorrichtung durchgeführt, wie sie in Siemens Forsch.-u. Entwickl.-Ber.Bd. 11 (1982), Seiten 322 bis 326, und in der europäischen Patentanmeldung 0 067 432 beschrieben ist. Die Schichtherstellung erfolgt in einer Sputteranlage vom Typ Perkin Elmer 4400 durch Sputtern von einem oder von 2 Targets (Co-Sputtern vergleiche zum Beispiel Siemens Forsch.-u. Entwickl.-Ber. Bd. 11 (1982), Seiten 145 bis 148). Während der Beschichtung werden das Referenzsubstrat sowie die übrigen Substrate unter dem Target hindurchgedreht. Bei dieser Art der Schichtherstellung wird die aktuelle Schichtdicke aus der Anzahl der Umdrehungen und der pro Umdrehung aufgebrachten Lagendicke (oder beim Co-Sputtern der Gesmatlagendicke=2 Teillagen), die in einem Vorversuch bestimmt werden, errechnet. Der elektrische Schichtwiderstand wird jeweils einmal pro Palettenumdrehung nach (oder vor) dem Aufbringen sämtlicher Teillagen gemessen und darhtlos aus der Sputteranlage an einen Empfänger übertragen und von dort von einem Rechner (MINC 23 von Digital Equipment) übernommen. Der Rechner berechnet die Istwerte der Regelgröße—wie beschrieben—entweder aus den Produkten $(\rho \cdot d)_i$ oder dem Lagenwiderstand $R_{Li}$ und vergleicht die Istwerte mit den Sollwerten. Bei Regelabweichungen legt er die Änderung des Stellgliedes gemäß einer vorgegebenen Antwortfunktion fest, die in einem Vorversuch aufgenommen wird als Zusammenhang zwischen der Regelgröße $\rho\infty$ und der Öffnung des Gaseinlaßventils. Die Steuerung des Stellgliedes (Gaseinlaßventil) erfolgt über eine ±5 V Spannung, die vom Rechner über einen Digital/Analog-Wandler erzeugt wird. Das steuerbare Gaseinlaßventil wurde von der Firma Vacuum General bezogen.

Die Beschichtung wird beendet, sobald ein vorgegebener Flächenwiderstandswert erreicht wird.

Beispiel 1:
Es werden folgende Parameter eingestellt:

| | |
|---|---|
| Sputtertarget: | Tantal (1200 W) |
| Sputtermethode: | DC-Magnetron |
| Sputtergas: | Argon (Druck: $10^{-2}$ mbar) |
| Dotier-(Fremd)gas: | Sauerstoff |
| Zeit pro Palettenumdrehung: | 6 sec |
| Aufgebrachte Lage pro Umdrehung: | 0,6 nm |
| Endwert des Flächenwiderstandes: | 41,6 $\Omega/\square$ |
| Sollwert $\rho\infty_i$: | konstant, 400 $\mu\Omega$cm |

a) Regelgröße $\rho\infty_i$ aus Produkten $(\rho \cdot d)_i$.

Vorversuch:
Der Zusammenhang zwischen $\rho\infty$ und der Öffnung des Gaseinlaßsystems ist aus dem in der Zeichnung befindlichen Kurvendiagramm ersichtlich. Dabei ist als Abszisse die Steuerspannung V in Volt für das Stellglied (Gaseinlaßventil) und als Ordinate $\rho\infty$ in $\mu\Omega$cm aufgetragen. Die Regelung erfolgt als Proportionalregelung mit Änderung des Stellgliedes ohne zeitliche Verzögerung.

| Umdre-hungs-zahl | Schicht-dicke [nm] | Gesamt-widerstand [$\Omega$] | Istwert der Regelgröße $\rho\infty_i$ [$\mu\Omega$cm] | Sollwert $\rho\infty$ [$\mu\Omega$cm] | Spannung für Stellglied [V] |
|---|---|---|---|---|---|
| 1 | 96 | 5000 | 300 | 400 | 0 |
| 2 | 1,2 | 2479 | 295 | 400 | 0 |
| 3 | 1,8 | 1619 | 280 | | |
| 4 | 2,4 | 1289 | 380 | 400 | +1 |
| 5 | 3,0 | 1084 | 410 | 400 | +1,2 |
| 6 | 3,6 | 930,7 | 395 | 400 | +1,1 |
| 7 | 4,2 | 816,7 | 400 | 400 | +1,0 |
| . | . | . | . | . | . |
| . | . | . | . | . | . |
| . | . | . | . | . | . |
| 159 | 95,4 | 41,6 | 400 | 400 | 1,0 |

oder
b) Regelgröße $\rho\infty_i$ aus dem Lagenwiderstand $R_{Li}$

| Umdre-hungs-zahl | Schicht-dicke [nm] | Gesamt-widerstand [Ω] | Lagen-widerstand [Ω] | Istwert der Regelgröße $\rho\infty_i$ [μΩcm] | Sollwert $\rho\infty$ [μΩcm] | Spannung für Stellglied [V] |
|---|---|---|---|---|---|---|
| 1 | 0,6 | 5000 | 5000 | 300 | 400 | 0 |
| 2 | 1,2 | 2479 | 4917 | 295 | 400 | 0 |
| 3 | 1,8 | 1619 | 4667 | 280 | 400 | 0 |
| 4 | 2,4 | 1289 | 6334 | 380 | 400 | +1,0 |
| 5 | 3,0 | 1084 | 6834 | 410 | 400 | +1,2 |
| 6 | 3,6 | 930,7 | 6584 | 395 | 400 | +1,1 |
| 7 | 4,2 | 816,7 | 6667 | 400 | 400 | +1,0 |
| . | . | . | . | . | . | . |
| . | . | . | . | . | . | . |
| . | . | . | . | . | . | . |
| 159 | 95,4 | 41,6 | 6667 | 400 | 400 | +1,0 |

Beispeil 2:

Sollwert $\rho\infty_i$ ist variabel

Das Ausführungsbeispiel beschreibt die Herstellung einer Tantalsilizid-Schicht durch Co-Sputtern, wobei gegen Ende der Beschichtung das Material mit Sauerstoff dotiert werden soll, damit eine Art Passivierungsschicht entsteht.

Es werden folgende Parameter eingestellt:

| | |
|---|---|
| Sputtertarget: | Tantal |
| Sputtermode: | DC Magnetron 1000 W |
| Sputtertarget: | Silizium |
| Sputtermode: | HF-Magnetron: 2000 W |
| Sputtergas: | Argon $10^{-2}$ mbar |
| Dotiergas: | Sauerstoff |
| Zeit pro Palettenumdrehung: | 6 sec |
| Dicke einer Doppellage: | 1,3 nm |
| Endwert des Gesamtwiderstandes: | 18,00 Ω/□ |
| Sollwert $\rho\infty_i$: | variabel. |

In einem Vorversuch wird analog zu Beispiel 1a der Zusammenhang zwischen $\rho\infty$ und der Ventilöffnung des Dosierventils, die über die Steuerspannung variiert werden kann, ermittelt.

Die Beschichtung erfolgt dann derart, daß das Gasdosierventil zunächst geschlossen ist (Steuerspannung −5V) und ca. 10 nm bevor die endgültige Schichtdicke erreicht ist, das Gasdosierventil geöffnet wird. Die Beschichtung wird dann solange fortgestezt, bis der gewünschte Endwiderstand erreicht ist.

| Umdre-hungs-zahl | Schicht-dicke [nm] | Gesamt-widerstand [Ω] | Istwert der Regelgröße $\rho\infty_i$ [μΩcm] | Sollwert $\rho\infty$ [μΩcm] | Spannung für Stellglied [V] |
|---|---|---|---|---|---|
| 1 | 1,3 | 3461 | 450 | 350 | −5 |
| 2 | 2,6 | 1629 | 400 | 350 | −5 |
| 3 | 3,9 | 1015 | 350 | 350 | −5 |
| 4 | 5,2 | 737 | 350 | 350 | −5 |
| . | . | . | . | . | . |
| . | . | . | . | . | . |
| . | . | . | . | . | . |
| 148 | 192,4 | 18,20 | 350 | 350 | −5 |
| 149 | 193,7 | 18,13 | 620 | 600 | 0 |
| 150 | 195 | 18,08 | 1000 | 1100 | +5 |
| 151 | 196,3 | 18,04 | 1050 | 1100 | +5 |
| 152 | 197,6 | 18,00 | 1100 | 1100 | +5 |

Wird die Schicht nicht kontinuierlich aufgestäubt, so kann analog zu Beispiel 1b auch der Lagenwiderstand $R_{Li}$ und daraus der Istwert $\rho\infty_i$ ermittelt werden.

Aus dem Versuchsprotokoll geht hervor, daß die ersten Lagen einen höheren spezifischen elektrischen Widerstand besitzen, da das aufgestäubte Material mit den adsorbierenden Schichten (zum Beispiel $H_2O$) auf dem Substrat reagiert. Ebenso springt der spezifische elektrische Widerstand beim Öffnen des Dosierventils nicht sofort auf den Endwert, da die in der Anlage abgeschiedenen Schichten ebenfalls den Sauerstoff adsorbieren. Erst nach einer gewissen Sättigung dieser Schichten steigt $\rho\infty_i$ auf den Endwert an.

Das Verfahren läßt sich ganz analog für die Produktion von Ni-Cr Dünnschichtwiderständen einsetzen, die mit Sauerstoff dotiert sein müssen, damit der Widerstand die richtige Temperaturcharakteristik bzw. Stabilität erreicht. Auch hier erfolgt die Regelung nach einem konstanten $\rho\infty_i$-wert. Dieses Material wird durch Elektronenstrahlverdampfen aus einer (Cr/Ni) oder zwei Quellen (Cr und Ni) hergestellt. Die Schichtdickenmessung erfolgt über ein Schwingquarzsystem. Die Aufdampfrate beträgt 1,5 nm/sec. Die Ist-Werte der Regelgröße werden jede Sekunde bestimmt. Die Substrate sind ortsfest.

Bei Cr-Si-O-Dünnschichtwiderständen wird beenfalls der Sauerstoffgehalt über einen definierten $\rho\infty$-Wert eingestellt. Zur Verbesserung der Haftung dieses Materials auf oxidischen Unterlagen werden die ersten Lagen ohne Sauerstoffdotierung abgeschieden, damit das Material intensiver mit dem Substrat reagieren kann.

**Patentansprüche**

1. Verfahren zur Kontrolle und Regelung des Einbaus von Dotiergasen in elektrisch leitende metallische Schichten, wie sie insbesondere in der Halbleiter- und Dünnschichttechnologie verwendet werden, während der Schichtherstellung durch Aufdampfen oder Aufstäuben, dadurch gekennzeichnet, daß

a) fortlaufend der momentane elektrische Schichtwiderstand $R_i$ und die momentane Schichtdicke $d_i$ gemessen bzw. bestimmt werden,

b) daraus der Istwert der Regelgröße $\rho\infty_i$ ermittelt wird,

c) der Istwert mit dem Sollwert von $\rho\infty_i$ für die Schichtdicke $d_i$ verglichen wird,

d) bei Regelabweichungen (Soll-Ist-Wert-Differenzen) die Dosierung des Einlaßventils für das Dotiergas in den Beschichtungsraum als Stellgröße entsprechend verändert wird und

e) bei Erreichen eines bestimmten Endwertes der Beschichtungsvorgang beendet wird.

2. Verfahren nach Anspruch 1, dadurch gekennzeichnet, daß die Regelgröße $\rho\infty_i$ als Steigung einer Geraden durch die Punktepaare $d_i$, $(\rho \cdot d)_i$ und $d_j$, $(\rho \cdot d)_j$ mit $0<j<i$ ermittelt wird, wobei $\rho_i$ der spezifische elektrische Widerstand der Schicht bei der Schichtdicke $d_i$ ist.

3. Verfahren nach Anspruch 1, dadurch gekennzeichnet, daß bei lageweisem Aufbringen der Schicht für $\rho\infty_i$ der Lagenwiderstand $R_{Li}$ der soeben aufgebrachten Schicht bestimmt wird.

4. Verfahren nach einem der Ansprüche 1 bis 3, dadurch gekennzeichnet, daß die Schichtdicke $d_i$ aus der Beschichtungszeit und der Beschichtungsrate errechnet wird.

5. Verfahren nach einem der Ansprüche 1 bis 4, dadurch gekennzeichnet, daß als Wert für die Beendigung des Beschichtungsprozesses die Schichtdicke, der gemessene Schichtwiderstand, der spezifische elektrische Widerstand, der Flächenwiderstand und/oder die Beschichtungszeit verwendet werden.

6. Verfahren nach einem der Ansprüche 1 bis 5, dadurch gekennzeichnet, daß in Abänderung des Verfahrens nach Anspruch 1 zur Kontrolle der Schichtzusammensetzung keine Regelung nach Verfahrensschritt c) und d) durchgeführt wird.

7. Verfahren nach einem der Ansprüche 1 bis 6, dadurch gekennzeichnet, daß die Messung von $R_l$ nach einer Änderung der Schichtdicke (Lagendicke) zwischen 0,1 und 50 nm, vorzugsweise nach einer Änderung im Bereich zwischen 1 bis 20 nm, erfolgt.

8. Verfahren nach einem der Ansprüche 1 bis 7, dadurch gekennzeichnet, daß die Änderung der Stellgröße gemäß der Regelcharakteristik eines Proportional-Reglers, eines Integral-Reglers, eines Proportional-Integral-Reglers, eines Proportional-Differential- oder eines Proportional-Integral-Differential-Reglers durchgeführt wird.

9. Verfahren nach einem der Ansprüche 1 bis 8, dadurch gekennzeichnet, daß die Meßwerte über einen Prozeßrechner erfaßt und verarbeitet werden.

10. Verfahren nach einem der Ansprüche 1 bis 9, dadurch gekennzeichnet, daß der Sollwert von $\rho\infty_i$ während der Schichtherstellung konstant ist.

11. Verfahren nach einem der Ansprüche 1 bis 9, dadurch gekennzeichnet, daß sich der Sollwert von $\rho\infty_i$ in Abhängigkeit von der Schichtdicke ändert.

12. Anwendung des Verfahrens nach einem der Ansprüche 1 bis 9 auf die Herstellung von elektrischen Widerstandsschichten aus Chrom-Silizium-Sauerstoff, Chrom-Nickel-Sauerstoff, Tantaloxinitrid ($TaO_xN_y$) oder Tantalnitrid.

13. Anwendung des Verfahrens nach einem der Ansprüche 1 bis 9 auf die Herstellung von mit Wasserstoff dotierten Siliziumschichten, Tantalsilizid-Schichten und Tantalsilizid-Nitrid-Zwischenschichten mit Sauerstoffdotierung.

14. Anwendung des Verfahrens nach einem der Ansprüche 1 bis 11 auf die Herstellung von Schichten mit einem über den Schichtquerschnitt variierenden Dotiergasgehalt.

## Revendications

1. Procédé pour commander et régler l'insertion de gaz dopants dans des couches métalliques électriquement conductrices, du type utilisé notamment dans la technologie des semiconducteurs et des couches minces, pendant la fabrication des couches par dépôt par évaporation ou par pulvérisation, caractérisé par le fait que

a) on mesure ou on détermine en permanence la résistance de couche électrique instantanée $R_l$ et l'épaisseur de couche instantanée $d_l$,

b) à partir de là, on calcule la valeur réelle de la grandeur de réglage $\rho\infty_l$,

c) on compare la valeur réelle à la valeur de consigne de $\rho\infty_i$ pour l'épaisseur de couche $d_l$,

d) dans le cas d'écarts de réglage (différences entre la valeur de consigne et la valeur réelle), on modifie de façon correspondante, en tant que grandeur de réglage, le dosage réalisé par la soupape d'admission pour le gaz dopant dans la chambre de dépôt, et

e) on arrête l'opération de dépôt lorsqu'une valeur finale déterminée est atteinte.

2. Procédé suivant la revendication 1, caractérisé par le fait qu'on détermine la grandeur de régalge $\rho\infty_i$ sous la forme d'une pente d'une droite passant par les couples de points $d_i(\rho \cdot d)_i$ et $d_j(\rho \cdot d)_j$ avec $0<j<i$, $\rho_i$ étant la résistance électrique spécifique de la couche pour l'épaisseur de couche ni.

3. Procédé suivant la revendication 1, caractérisé par le fait que dans le cas du dépôt de la couche en forme de strate, pour $\rho\infty_i$ on détermine la résistance $R_{Li}$ des strates de la couche que l'on vient de déposer.

4. Procédé suivant l'une des revendications 1 à 3, caractérisé par le fait qu'on calcule l'épaisseur de couche $d_i$ à partir de la durée et de la vitesse de dépôt.

5. Procédé suivant l'une des revendications 1 à 4, caractérisé par le fait qu'on utilise comme valeur pour arrêter l'opération de dépôt, l'épaisseur de couche, la résistance de couche mesurée, la résistance électrique, la résistance superficielle et/ou la durée de dépôt.

6. Procédé suivant l'une des revendications 1 à 5, caractérisé par le fait qu'à titre de variante du procédé suivant la revendication 1, pour contrôler la composition de la couche, on n'exécute pas le réglage conforme aux étapes opératoires c) et d).

7. Procédé suivant l'une des revendications 1 à 6, caractérisé par le fait que la mesure de $R_l$ est réalisée après une modification de l'épaisseur de la couche (épaisseur de strate) entre 0,1 et 50 nm et de préférence après une modification dans la gamme comprise entre 1 et 20 nm.

8. Procédé suivant l'une des revendications 1 à 7, caractérisé par le fait qu'on effectue la modification de la grandeur de réglage conformément à la caractéristique de régulation d'un régulateur à action proportionnelle, d'un régulateur à action intégrale, d'un régulateur à action proportionnelle et intégrale, d'un régulateur à action proportionnelle et différentielle, d'un régulateur à action proportionnelle, intégrale et différentielle.

9. Procédé suivant l'une des revendications 1 à 8, caractérisé par le fait qu'on enregistre et on traite les valeurs de mesure au moyen d'un calculateur de processus.

10. Procédé suivant l'une des revendications 1 à 9, caractérisé par le fait que la valeur de consigne de $\rho\infty_i$ est constante pendant la fabrication de la couche.

11. Procédé suivant l'une des revendications 1 à 9, caractérisé par le fait que la valeur de consigne de $\rho\infty_i$ varie en fonction de l'épaisseur de la couche.

12. Application du procédé suivant l'une des revendications 1 à 9 à la fabrication de couches résistives électriques formées de chrome-silicium-oxygène, chrome-nickel-oxygène, oxynitrure de tantale ($TaO_xN_y$) ou nitrure de tantale.

13. Application du procédé suivant l'une des revendications 1 à 9 à la fabrication de couches de silicium, dopé avec de l'hydrogène, de couches de siliciure de tantale et de couches intercalaires de siliciure-nitrure de tantale avec un dopage avec de l'oxygène.

14. Application du procédé suivant l'une des revendications 1 à 11 à la fabrication des couches possédant une teneur en gaz dopants qui varie sur la section transversale de la couche.

**Claims**

1. Process for monitoring and controlling the incorporation of doping gases in electrically conductive metallic films, as are used in particular in semi-conductor and thin-film technology, during the film manufacture by means of vapour deposition or sputtering, characterized in that
   a) the instantaneous electrical film resistance $R_i$ and the instantaneous film thickness $d_i$ are measured or determined constantly,
   b) the actual value of the controlled variable $\rho\infty_i$ is determined therefrom,
   c) the actual value is compared with the desired value $\rho\infty_i$ for the film thickness $d_i$,
   d) in the case of control deviations (desired-actual value differences), the metering of the inlet valve for the doping gas into the coating chamber is correspondingly varied as manipulated variable, and
   e) the coating operation is terminated when a given target value is reached.

2. Process according to Claim 1, characterized in that the controlled variable $\rho\infty_i$ is determined as gradient of a straight line through the point pairs $d_i$, $(\rho \cdot d)_i$ and $d_j$, $(\rho \cdot d)_j$ where $0<j<i$, $\rho_i$ being the specific electrical resistance of the film at a film thickness of $d_i$.

3. Process according to Claim 1, characterized in that, in the case of layer-by-layer application of the film, the layer resistance $R_{Li}$ of the film just applied is determined for $\rho\infty_i$.

4. Process according to one of Claims 1 to 3, characterized in that the film thickness $d_i$ is calculated from the coating time and the coating rate.

5. Process according to one of Claims 1 to 4, characterized in that the film thickness, the measured film resistance, the specific electrical resistance, the surface resistance and/or the coating time are used as value for terminating the coating process.

6. Process according to one of Claims 1 to 5, characterized in that, for monitoring the film composition, as a variation of the process according to Claim 1, no control is effected according to process step c) and d).

7. Process according to one of Claims 1 to 6, characterized in that $R_i$ is measured after a variation of the film thickness (layer thickness) between 0.1 and 50 nm, preferably after variation in the range between 1 and 20 nm.

8. Process according to one of Claims 1 to 7, characterized in that the manipulated variable is varied in accordance with the control characteristic of a proportional controller, of an integral controller, of a proportional-integral controller, of a proportional-differential controller or of a proportional-integral-differential controller.

9. Process according to one of Claims 1 to 8, characterized in that the measured values are recorded and processed by a process computer.

10. Process according to one of Claims 1 to 9, characterized in that the desired value of $\rho\infty_i$ is constant during the film production.

11. Process according to one of Claims 1 to 9, characterized in that the desired value of $\rho\infty_i$ varies as a function of the film thickness.

12. Application of the process according to one of Claims 1 to 9 to the manufacture of electrical resistance films composed of chromium-silicon-oxygen, chromium-nickel-oxygen, tantalum oxynitride ($TaO_xN_y$) or tantalum nitride.

13. Application of the process according to one of Claims 1 to 9 to the manufacture of silicon films doped with hydrogen, tantalum silicide films and tantalum silicide nitride intermediate films with oxygen doping.

14. Application of the process according to one of Claims 1 to 11 to the manufacture of films with a doping gas content varying across the film cross-section.